# EUROPEAN PATENT SPECIFICATION

(11) **EP 0 727 878 B1**
(45) Date of publication and mention of the grant of the patent: **12.06.2002**
(21) Application number: 96100476.9
(22) Date of filing: 15.01.1996
(51) Int. Cl.: H03M 1/14, H03M 1/06, H04N 5/44

(54) **Circuit for A/D conversion of a video RF or IF signal**
Schaltungsanordnung zur A/D-Umsetzung eines Videosignals mit Hoch- oder Zwischenfrequenz
Circuit pour la conversion analogique/numérique d'un signal vidéo à fréquence radio ou à fréquence intermédiaire

(30) Priority: 23.01.1995 EP 95400129
(43) Date of publication of application: 21.08.1996
(73) Proprietor: THOMSON multimedia, 92648 Boulogne Cédex (FR)
(72) Inventor: Boie, Werner, F-67200 Strasbourg (FR)
(74) Representative: Hartnack, Wolfgang, Dipl.-Ing.

(56) References cited:
- EP-A- 0 321 681
- EP-A- 0 488 282
- WO-A-90/03066
- US-A- 4 008 468
- US-A- 4 502 078
- US-A- 4 903 023
- US-A- 5 182 558
- ELECTRONIC DESIGN, 24 October 1991, HASBROUCK HEIGHTS, NEW JERSEY US, pages 47-59, XP000265950 GOODENOUGH F.: "12-Bit IC ADCs SAMPLE SIGNALS AT UP TO 20MHZ"
- 1980 IEEE INTERNATIONAL SOLID-STATE CIRCUITS CONFERENCE DIGEST OF TECHNICAL PAPERS, PHILADELPHIA, PA, USA, 13-15 FEB. 1980, 1980, NEW YORK, NY, USA, IEEE, USA, pages 12-13, XP002012040 CONNOLLY J J ET AL: "A monolithic 12b+sign successive approximation A/D converter"
- 1993 IEEE INTERNATIONAL SOLID-STATE CIRCUITS CONFERENCE. DIGEST OF TECHNICAL PAPERS. ISSCC. FIRST EDITION (CAT. NO.93CH3272-2), PROCEEDINGS OF IEEE INTERNATIONAL SOLID-STATE CIRCUITS CONFERENCE - ISSCC '93, SAN FRANCISCO, CA, USA, 24-26 FEB. 1993, ISBN 0-7803-0987-1, 1993, NEW YORK, NY, USA, IEEE, USA, pages 58-59, 263, XP002012041 MILLER G A ET AL: "A true 16 b self-calibrating BiCMOS DAC"

## Description

The invention relates to a circuit for A/D conversion.

The application of digital signal processing techniques in TV receiver design, especially for analog to digital conversion of RF and IF signals in the tuner, gets increasing importance. On the other hand due to the high frequency of said signals there are very strong requirements especially with respect to a high sampling frequency and a high dynamic resolution in the region of 12 bits and 25MHz. Taking into account the worst case reception of a desired signal having an IF amplitude inferior of 50 to 60dB with respect of the superimposed adjacent channel signals the required dynamic resolution amounts to about 20 bits. In addition to that the IF signal as it can be encountered in TV sets is also to be sampled at 80MHz at least.

In order to meet said requirements by using hardware in form of low-cost A/D converters a so-called two-step A/D conversion was proposed. Within such a circuit the incoming analog IF signal is fed via a sample and hold circuit to a first A/D converter with a restricted dynamic resolution. The output of said A/D converter is fed via a D/A converter to a subtracting stage fed on the other hand with the output of said sample and hold circuit. Output of said subtracting stage is fed via a second sample and hold circuit to a second A/D converter with higher dynamic resolution. Outputs of said first A/D converter and said second A/D converter are then combined in a summing stage the output of which is used as the final digitised IF of RF signal. Such a circuit is described in "Electronic Design", Oct. 24, 1991, pages 47-59.
WO-A-90/03066 discloses an A/D conversion circuit that includes two reduced-resolution A/D converters, of which one receives the D/A converted difference signal between the input signal and the output signal of the other A/D converter. The A/D conversion circuit includes a digital correction logic.
1993 IEEE INTERNATIONAL SOLID-STATE CIRCUITS CONFERENCE, DIGEST OF TECHNICAL PAPERS, ISSCC, FIRST EDITION (CAT. NO.93CH3272-2), PROCEEDINGS OF IEEE INTERNATIONAL SOLID-STATE CIRCUITS CONFERENCE - ISSCC'93, SAN FRANCISCO, CA, USA, 24-26 Feb. 1993, ISBN 0-7803-0987-1, 1993, NEW YORK, NY, USA, IEEE, USA, pages 58-59, 263, XP002012041 MILLER G.A. et al.: 'A True 16b Self-Calibrating BiCMOS DAC', and EP-A-0488282 show a D/A conversion circuit that is constructed using two D/A converters of which one corrects errors of the other, using all bits or some MSBs, respectively, of the D/A conversion circuit input signal.

It is an object of the invention to enable application of low cost A/D converters for RF or IF input signals in TVs or VCRs.
According to one embodiment of the invention a digital adaptive calibration offers new possibilities for hardware components with virtually higher accuracy.

The invention relates to a circuit for A/D conversion of a video RF or IF signal in a TV receiver or a video recorder wherein the input terminal is connected on the one hand via a first A/D converter of restricted dynamic resolution and on the other hand via a subtracting stage and a second A/D converter to inputs of a summing stage the output of said first A/D converter being connected via a D/A converter to a second input of said subtracting stage.

According to the invention there is inserted between said input terminal and said subtracting stage an analogue delay unit.

According to a first embodiment of the invention the output of said subtracting stage is connected via a series circuit, a low pass filter, a sample and hold circuit and a second A/D converter to the input of said summing stage. Preferably a correction algorithm unit is provided having its input connected to input of said first D/A converter and having it's output connected via a second D/A converter to the input of an adding stage inserted between output of said first D/A converter and input of said subtracting stage.

Said first A/D converter and said D/A converter are both controlled by a clock signal having an increased clock rate substantially higher than the normal clock rate used for the complete circuit.

In order that the invention may be better understood some examples of the invention are now described in combination with the accompanying drawing. Within the drawing
- Fig. 1: is a block diagram of an A/D conversion circuit for an IF TV signal incorporating the present invention,
- Fig. 2: is a block circuit for said first embodiment of the invention and

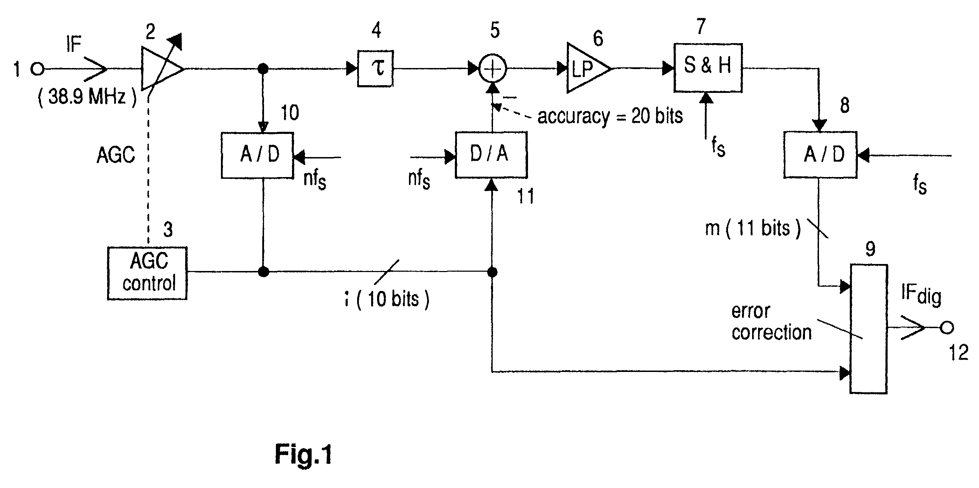

In Fig. 1 the incoming IF TV signal is fed from terminal 1 to controllable amplifier 2 which is controlled in it's amplification factor by AGC circuit 3. Amplification of amplifier 2 is controlled in such a way that within the succeeding stages the input signals will fully exploit the available dynamic ranges. In circuits according to prior art a sample and hold circuit is connected to the output of amplifier 2. This circuit is omitted here and replaced by an analogue delay unit 4 having its output connected to adding stage 5. Output voltage from amplifier 2 is also fed to a first A/D converter 10 having a restricted dynamic resolution of 1 bits, number of bits possibly might be 10 bits. Analogue output signal from converter 10 is fed via D/A converter 11 to input of subtracting stage 5 and therein subtracted from the IF signal provided by amplifier 2 and delayed by delay unit 4. The resulting difference signal at the output of subtracting stage 5 passes through band limiting amplifier 6 with an amplification factor of 2¹ and goes into a sample and hold circuit 7 fed by clock signal fs. Circuit 7 serves for second A/D conversion within A/D converter 8. Said converter 8 also has 1 bits resolution or even more for error correction. In order not to use a further sample and hold circuit between input of A/D converter 10 an output of D/A converter 11 these converters should run with an increased clock rate nfs. The outputs of A/D converter 10 and A/D converter 8 are both fed to summing stage 9 providing at its output terminal 12 the final digitised IF signal.

In order to make analogue delay unit 4 as simple as possible its delay time is kept a minimum by driving the A/D converter 10 and the D/A converter 11 with a maximum clock rate nfs.

In the following error correction of the signals will be more fully described. The error of a D/A converter is the difference between the actual analogue output and the output that is expected when a given digital code is applied to said converter. Sources of differences are given by gain error, zero error, linearity errors and noise. The latter, i.e. the internally generated random noise is not a major factor in D/A converters. Of much greater importance in D/A converters are interferences in the form of high amplitude low energy spikes appearing at the D/A converters output caused by coupling of digital signals in surprising variety of ways. However, this difficulty is substantially decreased in the circuit according to Fig. 1 in which sample and hold circuit 7 is provided in front of second A/D converter 8. As for the gain error an appropriate power supply should be made available considering the demanded logic levels and analogue output signals to be employed into this architecture. The offset error shows principally the same dependency of the supply voltage as the gain error does because for almost all bipolar converters instead of actually generating negative currency to correspond to negative numbers as a unipolar D/A converter is used and the output is offset by half a MSB. With respect to the linearity any two adjacent digital codes should result in measured output values that are exactly one LSB apart. Any deviation of the measured-step-from the ideal difference is called differential non-linearity express in sub multiples of one LBS. The differential non-linearity is usually caused by the tolerances of the resistors in the D/A converter. An accuracy of about 12 bits can be achieved by including laser trimmable thin film resistor.

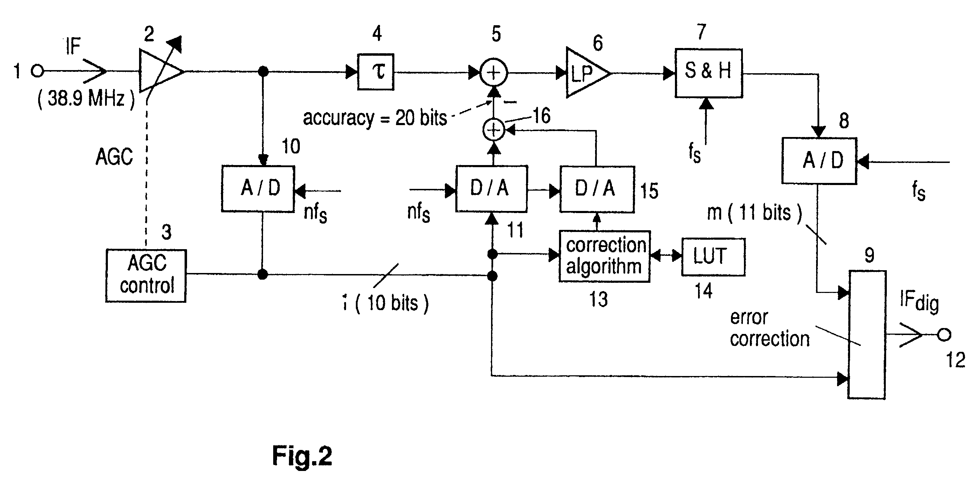

Fig. 2 shows an embodiment of the invention additionally including error correction. Digital input signal fed to D/A converter 11 additionally is fed to correction algorithm unit 13. This algorithm is based on empirically determined data stored in a look-up table (LUT) 14. Output of unit 13 is fed to input of a second D/A converter 15 having its output connected to input of an adding stage 16 inserted between output of D/A converter 11 and input of subtracting stage 5. Unit 13 drives D/A converter 15 with an accordingly reduced voltage reference compared to the main D/A converter 11. Within stage 16 the analogue correction signal from D/A converter 15 is added to the output of main D/A converter 11 thus allowing the application of a D/A converter with reduced accuracy.

The achievable high dynamic range of the proposed A/D conversion architecture would permit to eliminate the SAW-filter in the current analogue IF module, this making free the way for a fully integrated digital IF solution, prefeably on one single chip.

## Claims

1. Circuit for A/D conversion of a video RF or IF signal (1) for a TV receiver or a video recorder, including:
- a first A/D converter (10) receiving the input signal of said A/D conversion circuit and having a restricted resolution when compared to that of the whole A/D conversion circuit, wherein the input signal of said first A/D converter also passes through analog delay means (4) to the first input of a subtraction stage (5);
- a D/A converter (11) receiving the output signal of said first A/D converter, wherein the output signal of said D/A converter is subtracted in said subtraction stage from its first input signal;
- a summing stage (9) in which from the output signals of said first A/D converter (10) and a second A/D converter (8) the output signal (12) of said A/D conversion circuit is formed,
**characterised by**
- a lowpass filter (6) passing the output signal of said subtraction stage through a sample-and-hold circuit (7) to the input of said second A/D converter (8).

2. Circuit according to claim 1, wherein the output signal of said first A/D converter (10) is also fed to the input of a correction algorithm unit (13) passing its output signal to a further D/A converter (15), the output signal of which further D/A converter is added (16) to the output signal of said D/A converter (11) in order to feed a corrected D/A converter output signal to said subtraction stage (5).

3. Circuit according to claim 1 or 2, wherein said first A/D converter (10) and said D/A converter (11) are clocked by a clock signal having an increased clock rate (nfs) substantially higher than the clock rate (fs) for said second A/D converter (8) and said sample-and-hold circuit (7).

## Patentansprüche

1. Schaltung für die A/D-Umwandlung eines Video-HF- oder - ZF-Signals (1) für einen Fernsehempfänger oder einen Videorecorder, umfassend:
- einen ersten A/D-Wandler (10), der das Eingangssignal der A/D-Wandler-Schaltung empfängt und eine begrenzte Auflösung im Vergleich zu der der gesamten A/D-Wandler-Schaltung hat, wobei das Eingangssignal des ersten A/D-Wandlers auch durch analoge Verzögerungsmittel (4) zu dem ersten Eingang einer Subtraktionsstufe (5) verläuft;
- einen D/A-Wandler (11), der das Ausgangssignal des ersten A/D-Wandlers empfängt, wobei das Ausgangssignal des D/A-Wandlers in der Subtraktionsstufe von seinem ersten Eingangssignal subtrahiert wird;
- eine Summierungsstufe (9), in der von den Ausgangssignalen des ersten A/D-Wandlers (10) und eines zweiten A/D-Wandlers (8) das Ausgangssignal (12) der A/D-Wandler-Schaltung gebildet wird, **gekennzeichnet durch:**
- ein Tiefpassfilter (6), das das Ausgangssignal der Subtraktionsstufe **durch** eine Abtast- und Halteschaltung (7) zu dem Eingang des zweiten A/D-Wandlers (8) durchlässt.

2. Schaltung nach Anspruch 1, bei der das Ausgangssignal des ersten A/D-Wandlers (10) auch dem Eingang einer Korrektur-Algorithmus-Einheit (13) zugeführt wird, deren Ausgangssignal zu einem weiteren D/A-Wandler (15) verläuft, wobei das Ausgangssignal des weiteren D/A-Wandlers dem Ausgangssignal des D/A-Wandlers (11) hinzugefügt wird, um der Subtraktionsstufe (5) ein korrigiertes D/A-Wandler-Ausgangssignal zuzuführen.

3. Schaltung nach Anspruch 1 oder 2, bei der der erste A/D-Wandler (10) und der D/A-Wandler (11) durch ein Taktsignal getaktet werden, das eine erhöhte Taktrate (nfs) hat, die wesentlich höher als die Taktrate (fs) für den zweiten A/D-Wandler (8) und die Abtast- und Halteschaltung (7) ist.

## Revendications

1. Circuit de conversion A/N d'un signal vidéo HF ou Fi (1) pour un téléviseur ou un magnétoscope comprenant:
- un premier convertisseur A/N (10) qui reçoit le signal d'entrée dudit circuit de conversion A/N et a un définition réduite comparée à celle de l'ensemble du circuit de conversion A/N, dans lequel le signal d'entrée dudit premier convertisseur A/N traverse également un moyen à retard analogique (4) pour aller vers la première entrée d'un étage soustracteur (5);
- un convertisseur N/A (11) qui reçoit le signal de sortie dudit premier convertisseur A/N, dans lequel le signal de sortie dudit convertisseur N/A est soustrait dans ledit étage de soustraction de son premier signal d'entrée;
- un étage additionneur (9) dans lequel à partir des signaux de sortie dudit premier convertisseur A/N (10) et d'un deuxième convertisseur A/N (8) le signal de sortie (12) dudit circuit de conversion A/N est généré,
**Caractérisé par**
- un filtre passe-bas (6) qui transmet le signal de sortie dudit étage soustracteur à travers un circuit échantillonneur (7) à l'entrée dudit deuxième convertisseur A/N (8).

2. Circuit selon la revendication 1, dans lequel le signal de sortie dudit premier convertisseur A/N (10) est également fourni à l'entrée d'une unité algorithmique de correction des erreurs (13) qui transmet son signal de sortie à un autre convertisseur N/A (15), dont le signal de sortie est ajouté (16) au signal de sortie dudit convertisseur N/A (11) afin de fournir un signal de sortie du convertisseur N/A corrigé audit étage soustracteur (5).

3. Circuit selon la revendication 1 ou 2, dans lequel ledit premier convertisseur A/N (10) et ledit convertisseur N/A (11) sont pilotés par un signal d'horloge dont la fréquence est augmentée (nfs) sensiblement par rapport à la fréquence d'horloge (fs) dudit deuxième convertisseur A/N (8) et dudit circuit échantillonneur (7).
